# EUROPÄISCHE PATENTSCHRIFT

(11) **EP 2 422 132 B1**
(45) Veröffentlichungstag und Bekanntmachung des Hinweises auf die Patenterteilung: **16.09.2015**
(21) Anmeldenummer: 10720138.6
(22) Anmeldetag: 22.04.2010
(51) Int. Cl.: F21V 21/002, F21V 27/00, F21V 31/00, G09F 9/33, H01L 25/075, H01L 33/48, H01R 4/24, H01R 33/09, H01R 12/72, F21Y 101/02

(54) **GEHÄUSTES LED-MODUL MIT INTEGRIERTER ELEKTRONIK**
HOUSED LED MODULE COMPRISING INTEGRATED ELECTRONICS
MODULE DE LED ENCAPSULÉ À ÉLECTRONIQUE INTÉGRÉE

(30) Priorität: 24.04.2009 DE 202009006110 U; 02.10.2009 DE 202009013278 U
(43) Veröffentlichungstag der Anmeldung: 29.02.2012
(73) Patentinhaber: Tridonic Jennersdorf GmbH, 8380 Jennersdorf (AT)
(72) Erfinder: DOBOS, Janos, H-9700 Szombathely (HU); HOCHFILZER, Christian, A-8010 Graz (AT); GUMHOLD, Jürgen, A-8380 Jennersdorf (AT)
(74) Vertreter: Rupp, Christian
(86) Internationale Anmeldenummer: PCT/EP2010/055354
(87) Internationale Veröffentlichungsnummer: WO 2010/122108

(56) Entgegenhaltungen:
- WO-A2-2006/042271
- US-A- 5 045 981
- US-A- 5 672 000
- US-A- 5 967 649
- US-A1- 2005 207 151
- US-A1- 2006 002 125
- US-A1- 2006 284 199
- US-A1- 2007 190 845
- US-A1- 2008 186 731
- US-B1- 7 160 140

## Beschreibung

Die vorliegende Erfindung betrifft ein gehäustes LED-Modul für Leuchtdioden ("LEDs") mit integrierter Elektronik, welches eine flexible Montage der LEDs bzw. des Moduls ermöglicht.

Aus dem Stand der Technik sind LED-Module bekannt, welche im Wesentlichen aus einem Modul mit wenigstens einem LED-Chip bestehen.
WO9002906A1 zeigt einen beleuchtbaren Kabelbaum, der elektrische Leiter aufweist, die an eine elektrische Stromversorgung angeschlossen sind. Eine Vielzahl von Leuchtelementen befindet sich in regelmäßigen Abständen auf dem Kabelbaum, diese sind mit elektrischen Leitern verbunden. Die elektrischen Leiter befinden sich nebeneinander in einem Flachleiter, der von einer Isolationsschicht umgeben ist. An den Stellen, an denen die Leuchtelemente angebracht werden, wird diese Isolationsschicht auf der Oberseite entfernt. Jedes Leuchtelement und die daran anliegende Stelle des Flachleiters wird von einem wasserdichten Gehäuse geschützt. Das Leuchtelement ist dabei im Gehäuse so ausgerichtet, dass es auf dem Flachleiter sitzt und von diesem weg leuchtet.

US2005040421A1 zeigt eine Leuchtvorrichtung mit mindestens zwei Anschlüssen und einem Substrat, auf dem sich mindestens eine LED und ein integrierter Schaltkreis befindet, und welches zum Schutz verkapselt ist. Der integrierte Schaltkreis sorgt für einen konstanten Versorgungsstrom, der an die Betriebseigenschaften der LED angepasst ist. Somit lässt sich die Leuchtstärke genau einstellen.

EP1055256B1 offenbart ein konfektionierbares LED-Leuchtpanel beinhaltend einen Aufbau von elektrisch leitenden Strukturen, Isolationsstrukturen und elektrischen Anschlussflächen sowie LED-Chips, welche von diesem Aufbau getragen werden und mittels der elektrischen Anschlussflächen elektrisch parallel kontaktierbar sind. Das LED-Leuchtpaneel weist dabei eine vorgebare Verteilung der LED-Chips auf und ist nachträglich in beliebige, je für sich alleine funktionsfähige Teilstücke zertrennbar. US2007/0190845 offenbart ein weiters gehäustes LED Modul des Stands der Technik.

Die LED-Kettenmodule aus dem Stand der Technik weisen allerdings einen geringen Schutz gegen mechanische Beanspruchung und eine geringe Flexibilität auf, was deren Einsatzmöglichkeiten stark einschränkt.

Ziel der vorliegenden Erfindung ist es daher, ein gehäustes LED-Modul bereitzustellen, das in flexibler Weise elektrisch kontaktierbar ist und Anforderungen an Staub- und Feuchtigkeitsschutz erfüllt. Diese Anforderungen können ausgedrückt werden bspw. durch die Schutzklassen in der IP Norm, DIN EN 60529: Schutzarten durch Gehäuse (IP Code).

Die Aufgabe der vorliegenden Erfindung wird durch die Merkmale des unabhängigen Anspruchs gelöst. Die abhängigen Ansprüche bilden den zentralen Gedanken der Erfindung in besonders vorteilhafter Weise weiter.

Im Rahmen der Erfindung wird unter LED-Modul verstanden:
- ein Träger oder eine Platine,
- wenigstens einen darauf angebrachter LED-Chip, und
- wenigstens Teile der Ansteuerelektronik für den wenigstens einen LED-Chip .

Dabei kann der wenigstens eine LED-Chip in COB (Chip on Board) oder SMD montiert sein.

Die vorliegende Erfindung behandelt ein gehäustes LED-Modul aufweisend ein derartiges LED-Modul, wobei das LED-Modul innerhalb eines verschließbaren Gehäuses angeordnet ist, und wobei das Gehäuse an einer Stirnseite mindestens zwei steife nach Außen stehende Leiter aufweist, die dazu ausgelegt sind, durch Einschneiden in die Isolierung mindestens zweier im Wesentlichen rechtwinklig zugeführter Versorgungsleiter diese elektrisch zu kontaktieren.

Unter LED wird im Rahmen der Erfindung ein LED-Chip verstanden. Dieser kann bspw. "Face-Up" oder "Face-Down" auf dem LED-Modul angeordnet sein. Zudem kann eine Vergussmasse auf dem Modul vorgesehen sein, welche zumindest den wenigstens einen LED-Chip überzieht. Dementsprechend kann der LED-Chip durch die Vergussmasse eingekapselt sein. Die Vergussmasse besteht vorzugsweise aus ursprünglich fliessfähigem, danach ausgehärteten Kunststoff und wird mit Hilfe eines Dispens-Verfahrens auf das Modul aufgetragen.

An Stelle der Vergussmasse oder zusätzlich dazu kann ein mechanischer Schutz der LEDs vorgesehen sein. Dieser kann direkt auf dem LED-Modul aufgebracht sein. Beispielsweise können sogenannte Globe-Tops, also durch Dispensen und folgendem Aushärten aufgebrachte Vergussmassen, vorzugsweise etwa in Form einer Sphäre, in Kontakt auf den LED-Chip aufgebracht sein.

(Alternativ können auch vorgefertigte Elemente auf dem LED-Chip aufgebracht sein.)

Die Vergussmasse kann Farbkonversionspartikel und/oder Streupartikel enthalten. Die LED(s) des LED-Moduls emittiert vorzugsweise Licht einer Wellenlänge zwischen 420-490nm. Durch die Farbkonversionspartikel, welche in der die LED umgebende Vergussmasse enthalten sind, wird das Licht wenigstens teilweise in Licht einer höheren Wellenlänge konvertiert. Die vorliegende Erfindung beschränkt sich nicht auf LEDs einer bestimmten Wellenlänge. Im Rahmen der Erfindung kann jede beliebige monochromatische LED auf dem LED-Modul angeordnet sein. Beispielsweise kann auch eine rot emittierende LED auf dem LED-Modul angebracht sein, welche mit Vergussmasse mit oder ohne Farbkonversionspartikeln umgeben ist. Zudem können LED-Chips, welche mit Vergussmassen mit unterschiedlichen Farbkonversionspartikeln überzogen sind, auf dem LED-Modul angeordnet sein.

Die Vergussmasse ist vorzugsweise kalottenförmig oder halbkugelförmig auf den LED-Chip aufgetragen.

Es ist jedoch auch möglich, das Farbkonversionsmittel separat in dem Gehäuse des Moduls angeordnet sind. Dementsprechend kann eine Vergussmasse mit Farbkonversionsmitteln räumlich getrennt von dem LED-Chip angeordnet sein.

Die Steuerelektronik des LED-Chips ist vorzugsweise auf der Rückseite des Trägers des LED-Moduls angebracht. Alternativ oder zusätzlich kann sie aber auch auf der gleichen Oberfläche wie der LED-Chip des Moduls angebracht sein. Sie kann sich auch zumindest teilweise innerhalb des Trägers bzw. der Platine des Moduls befinden. Die Steuerelektronik des LED-Moduls umfasst dabei vorzugsweise eine Transistorschaltung oder weitere Elektronik und eine Schnittstelle für eine Kommunikationseinrichtung bzw. einen Kommunikationsbus. Weiterhin kann sie einen integrierten Schaltkreis aufweisen, vorzugsweise einen ASIC (Anwendungsspezifische Integrierte Schaltung). Außerdem ist kann sie über eine Sensorik, wie beispielweise einen Temperatur-, Helligkeits- oder Farbsensor, verfügen.

Das Gehäuse des LED-Moduls ist vorzugsweise zweiteilig ausgebildet und umfasst dabei eine Ober- und eine Unterschale. Diese werden vorzugsweise mit Hilfe von Schnappverschlüssen miteinander verbunden. Das Gehäuse kann jedoch auch einteilig ausgeführt sein. Hierzu kann beispielsweise ein Scharnier zur Verbindung der Ober- und Unterschale vorhanden sein. Die Ober- und Unterschale können selektiv miteinander verbunden werden.

Das Gehäuse des LED-Moduls ist vorzugsweise derart ausgeführt, dass es das LED-Modul, auf welchem sich die wenigstens eine LED befindet, vollständig umschließt.

Die Oberfläche des Moduls weist vorzugsweise eine bspw. nach außen konisch sich erweiternde Ausnehmung auf, durch die der LED-Chip nach Aussen hin exponiert ist. Vorzugsweise ist der LED-Chip im Zentrum der Ausnehmung angeordnet.

Durch die Ausnehmung in dem Modul steht die LED bzw. die vorzugsweise kalotten- oder halbkugelförmige Vergussmasse, welche den LED-Chip umgibt, hervor. Dadurch wird eine maximale Lichtausbeute der wenigstens einen LED des Moduls erreicht.

In einer bevorzugten Ausführungsform ist wenigstens die Oberfläche des LED-Moduls im Bereich der konischen Ausnehmung reflektierend ausgestaltet. Hierdurch wird Licht, welches durch die Oberfläche der Vergussmasse der LED austritt innerhalb der Ausnehmung des Gehäuses reflektiert.

Die Oberfläche des Moduls kann beispielsweise aus weißem reflektierendem Kunststoffmaterial geformt sein.

Der Winkel der konischen Ausnehmung beträgt vorzugsweise zwischen 100 und 150°. Durch diese erfindungsgemäße Ausgestaltung der Ausnehmung im Gehäuse des LED-Moduls wird eine weitere Maximierung der Lichtausbeute der LED erzielt.

Alternativ kann die mindestens eine LED jedoch auch auf einer ebenen Oberfläche des Moduls angeordnet sein. Oberhalb der LED kann sich dabei eine weitere transluzente Platte befinden, die streuförmige Eigenschaften aufweist. Diese Platte kann auch Teil des Gehäuses sein.

Es besteht außerdem die Möglichkeit, auf jeden LED-Chip ein einzelnes linsenförmiges Element anzubringen.

Diese Elemente können vorgefertigt oder im fliessfähigen Zustand aufgebracht werden und im Anschluß ausgehärtet werden.

In einem weiteren Aspekt der Erfindung weist das Modul einen Träger und einen vorzugsweise aus mehreren Teilen bestehenden Rahmen auf.

Auf dem Träger ist dabei vorzugsweise eine Vielzahl an LED-Chips dicht aneinander gepackt angebracht und von dem Rahmen umrandet.

Die Vielzahl an LED-Chips kann durch eine zumindest teilweise transluzente Schicht bedeckt sein, wobei die Schicht Leuchtstoffmaterial und Streuteilchen enthalten kann.

Vorzugsweise befindet sich oberhalb der zumindest teilweise transluzenten Schicht eine oder mehrere vorgefertigte Linsen.

Die Erfindung sieht weiterhin vor, dass die elektrische Kontaktierung an der Stirnseite des Gehäuses, vorzugsweise mittels eines Montageadapters zugentlastet wird.

Der Montageadapter kann dabei mechanisch am Gehäuse fixiert werden. Der Montageadapter ist U-förmig ausgebildet und greift vorzugsweise clipartig in eine Hinterschneidung im Gehäuse ein. Das Gehäuse kann mehrere Hinterschneidungen aufweisen. Auf diese Weise lässt sich die Position, in der der Montageadapter mechanisch am Gehäuse fixiert ist, variabel einstellen.

Das Gehäuse und der Montageadapter weisen bei Zusammenfügen eine Nut auf, durch die die Versorgungsleiter geführt werden. Die Nuten sind vorzugsweise Kabelführungen, welche derart dimensioniert sind, dass eine Presspassung zwischen den einzelnen Versorgungsleitern und der Nut zwischen Gehäuse und Montageadapter vorliegt. Dementsprechend sind die Versorgungsleiter fest in den dafür vorgesehenen Kabelführungen eingeklemmt. Die Größe der Nut lässt sich an die Versorgungsleiter so anpassen, dass eine elektrische Kontaktierung sichergestellt ist. Dies wird insbesondere durch die variable Einstellung der Position des Montageadapters erreicht.

Die elektrische Kontaktierung des Gehäuses erfolgt vorzugsweise durch eine Steckverbindung, in die ein steifer Leiter eingeschoben ist, der zu den Versorgungsleitern führt.

Der steife Leiter durchsticht dabei vorzugsweise die Isolierung der Versorgungsleiter. Auf diese Weise kann eine elektrische Kontaktierung hergestellt werden.

Bei den Versorgungsleitern kann es sich vorzugsweise um handelsübliche isolierte Drähte handeln. Denkbar ist jedoch auch ein Flachleiter, der mehrere Leiter integriert.

Die Versorgungsleiter dienen zur Stromversorgung des mindestens einen LED-Moduls. Zudem können mit Hilfe der Versorgungsleiter mehrere LED-Module verbunden werden.

Der steife Leiter besteht vorzugsweise aus mindestens 2 Spitzen, die in ihrem Niveau so versetzt sind, dass sie unterschiedliche Versorgungsleiter kontaktieren.

Die spitzen Leiter durchstechen vorzugsweise erst ein Klebeband, bevor sie auf die Isolierung der Leiter treffen. Mit diesem Klebeband kann ein Montageadapter für die Leiter auf eine plane Stirnseite des LED-Modulgehäuses geklebt werden.

Zusätzlich oder alternativ zu dem Klebeband kann sich zwischen dem Gehäuse und dem Montageadapter ein Dichtungselement befinden, das vorzugsweise von den nach außen stehenden Leitern durchstochen wird.

In einem nicht beanspruchten Ausführungsbeispiel weist ein gehäustes LED-Modul ein LED-Modul mit wenigstens einem darauf angeordneten LED-Chip auf, wobei das LED-Modul innerhalb eines verschließbaren Gehäuses angeordnet ist. Das Gehäuse hat auf zwei gegenüberliegenden Seiten Nuten zum Führen von jeweils einem Leiter, wobei sich innerhalb jeder Nut ein Kontaktierungselement befindet, das dazu ausgelegt ist, durch Einschneiden in die Isolierung des entsprechenden im Wesentlichen rechtwinklig zugeführten Leiters diese elektrisch zu kontaktieren.

Die Nuten des Moduls können dabei auf dessen Längsseite angeordnet sein und/oder auf den Seiten, die sich orthogonal zur Ebene befinden, auf der die wenigstens eine LED angebracht ist.

Das Kontaktierungselement weist vorzugsweise einen Schlitz auf, in den der entsprechende Leiter eingeschoben wird.

Der Schlitz weist eine solche Größe auf, dass beim Hineinschieben die Isolierung der Leitung durchschnitten wird. Somit kann ein elektrischer Kontakt mit der Leitung realisiert werden. Dabei hat der Schlitz vorzugsweise eine solche Breite, dass der Leiter, beispielsweise ein Draht oder Litzen, nicht angeschnitten wird.

In einer bevorzugten Ausführungsform weist das LED-Modul für jeden Leiter eine Klammer auf, die der Leiter an der Stelle der Kontaktierung mit dem Kontaktierungselement umgibt und das LED-Modul an einer vorgegebenen Stelle auf den Leitern mechanisch fixiert.

Die Klammer kann einen Hohlraum aufweisen, in den das Kontaktierungselement aufgenommen wird, womit dieses geschützt und nach außen isoliert ist.

Die Klammer fungiert vorzugsweise als Zugentlastung für den Leiter, womit die Kontaktierungsstelle des Leiters mechanisch nicht belastet wird.

Die Klammer kann eine solche Größe aufweisen, dass sie in die Nuten des Gehäuses einfügbar ist.

Vorzugsweise wird das Kontaktierungselement durch Umspritzen in das LED-Modul integriert.

Das Kontaktierungselement ist vorzugsweise elektrisch leitfähig und kann aus einem Metall oder einer Metalllegierung bestehen.

Die Klammer ist vorzugsweise elektrisch isolierend und kann aus einem Kunststoff bestehen.

Innerhalb des gehäusten LED-Moduls erfolgt die elektrische Kontaktierung vorzugsweise über eine Klammer, die eine elektrische Verbindung zwischen dem steifen Leiter und der Oberseite des Moduls herstellt.

In einem weiteren Aspekt behandelt die vorliegende Erfindung ein gehäustes LED-Modul, bei dem das Gehäuse und insbesondere die Oberschale einen im Wesentlichen optisch durchlässigen Bereich aufweist, welcher eine die Lichtabstrahlcharakteristik der LED verändernde Funktion aufweist.

In einer bevorzugten Ausführungsform weist der optisch durchlässige Bereich eine Streuwirkung, eine Reflektorwirkung und/oder eine Farbkonversionswirkung auf, welche die Lichtabstrahlcharakteristik der LED verändert.

In einer bevorzugten Ausführungsform kann die gesamte Oberschale transparent ausgestaltet sein. Alternativ ist allerdings auch denkbar, dass nur der Bereich oberhalb der wenigstens einen LED transparent gestaltet ist, während die anderen Bereiche durch andere Materialwahl, durch Oberflächenbearbeitung (Aufrauen, etc.) oder aber Lackieren undurchsichtig sind. Somit kann der Anschlussbereich der Verbindungsleitungen wie auch die Elektronik auf dem Modul von oben nicht einsehbar sein.

Der optisch durchlässige Bereich kann vorzugsweise als Kunststofflinse ausgebildet sein. Der optisch durchlässige Bereich ist vorzugsweise koaxial mit der LED angeordnet. Die Linse kann dabei eine Streu- und/oder Beugefunktion aufweisen.

Der LED-Chip des Moduls kann von einer ausgehärteten, kalottenförmigen Vergussmasse umgeben sein, welche Farbkonversionsmittel umfasst. Des Weiteren kann statt der Vergussmasse ein sogenanntes Globe Top, welches beispielsweise aus transparentem Kunststoff besteht, als mechanischer Schutz der LED vorgesehen sein.

In Richtung des Ausstrahlwinkels der LED kann darüber hinaus eine holographische Folie angebracht sein. Diese hat die Funktion, die Abstrahlcharakteristik des LED-Moduls zu verändern.

Das Gehäuse weist vorzugsweise Positioniermittel auf, welche derart ausgestaltet sind, dass ein Verschieben des Moduls im Inneren des Gehäuses verhindert wird.

In einer bevorzugten Ausführungsform sind die Positioniermittel an die Unterschale angespritzt und greifen in Ausnehmungen oder Vertiefungen des Moduls ein. Die Positioniermittel können profilierte Elemente sein. Dementsprechend kann das Modul in die Unterschale definiert und in der richtigen Orientierung gelegt werden, bevor das Gehäuseoberteil aufgeklippt und ggf. auch abgedichtet wird.

Die Positioniermittel umfassen vorzugsweise wenigstens einen von der Unterschale hervorstehenden Dorn, welcher in einer Nut des Moduls geführt wird. Zudem ist das Modul vorzugsweise durch eine umlaufende Rahmenfläche der Unterschale des Gehäuses geführt.

Die Unterschale des Gehäuses weist vorzugsweise eine umlaufende Nut auf, welche mit einer umlaufenden Feder der Oberschale in Eingriff steht. Dabei sind die umlaufende Nut bzw. die Feder derart gestaltet, dass ein falsches Aufbringen der Oberschale auf die Unterschale des Gehäuses verhindert wird. Die mittels der Feder-Nut-Verbindung in Eingriff stehenden Gehäuseteile bewirken eine Versiegelung des Gehäuses gegen eintretenden Schmutz, Staub und Feuchtigkeit.

Alternativ kann eine Versiegelung dadurch realisiert werden, dass das Gehäuse umspritzt wird. Das Gehäuse wird durch das Umspritzen dicht ausgeführt.

Vorzugsweise wird durch die erfindungsgemäße Ausführung des Gehäuses ein Staub- und Feuchtigkeitsschutz der Norm IP66 oder höhere Schutzklasse erzielt.

Zudem wird vorzugsweise zum Zusammenbau der beiden Gehäuseteile ein flüssiges Kunststoff bzw. Epoxidmaterial zwischen die beiden Gehäusehälften eingelegt oder dispensiert, das für eine randseitige Dichtung sorgt. Zwischen den Anschlusskabeln ist vorzugsweise in einer der beiden Gehäuseschalen eine Nut vorgesehen, durch die hindurch der Raum im Bereich der Anschlusskabel mit Epoxid gefüllt werden kann, um auch in diesem Bereich einen Staub- und Feuchtigkeitsschutz zu schaffen.

Derartig geschützte LED-Module sind insbesondere für Außenanwendungen wie beispielsweise für Reklametafeln etc. geeignet.

Um eine Anbringung des Gehäuses auf externen Oberflächen zu ermöglichen, weist vorzugsweise wenigstens eines der Gehäuseteile Befestigungsmittel auf. Diese können beispielsweise an dem Gehäuse angebrachte Anschraublaschen sein. Das erfindungsgemäße Gehäuse kann aber auch durch Verkleben (beispielsweise mit doppelseitigem Klebeband) an der Unterseite der Unterschale des Gehäuses montiert werden. Hierdurch können beispielsweise Leuchtbuchstaben auf externen Oberflächen auf einfache Art angebracht werden.

Ein bevorzugtes Ausführungsbeispiel des erfindungsgemäßen LED-Moduls ist in den Zeichnungen darstellt und wird in der nachfolgenden Beschreibung näher erläutert.
- Fig. 1: zeigt eine Explosionsansicht einer bevorzugten Ausführungsart des erfindungsgemäßen gehäusten LED-Moduls.
- Fig. 2: zeigt eine erste perspektivische Seitenansicht des gehäusten LED-Moduls nach Abbildung 1.
- Fig. 3: zeigt die erfindungsgemäße Kontaktierung des LED-Moduls mit den Versorgungsleitern.
- Fig. 4: zeigt eine perspektivische Ansicht der Passform des Moduls im Gehäuse.
- Fig. 5: zeigt eine Draufsicht auf die Oberseite des gehäusten LED-Moduls.
- Fig. 6: zeigt eine Draufsicht auf den Montageadapter des gehäusten LED-Moduls.
- Fig. 7: zeigt eine Explosionsansicht einer zweiten bevorzugten Ausführungsart des erfindungsgemäßen gehäusten LED-Moduls.
- Figur 8: zeigt eine perspektivische Seitenansicht des zusammengebauten gehäusten LED-Moduls aus Fig. 7.
- Figur 9: zeigt eine Seitenansicht des LED-Moduls aus Fig. 7.
- Figur 10: zeigt eine Draufsicht auf das LED-Modul aus Fig. 7.
- Fig. 11: zeigt eine weitere Ausführungsform des Moduls als Träger mit mehrteiligem Rahmen in einer perspektivischen Ansicht.
- Figur 12: zeigt eine Schnittansicht des Moduls durch den Schnitt VII-VII in Figur 7.
- Figur 13a: zeigt eine perspektivische Ansicht eines ersten Rahmenteils eines Moduls gemäß Figur 7.
- Figur 13b: zeigt eine perspektivische Ansicht eines zweiten Rahmenteils eines Moduls gemäß Figur 7.

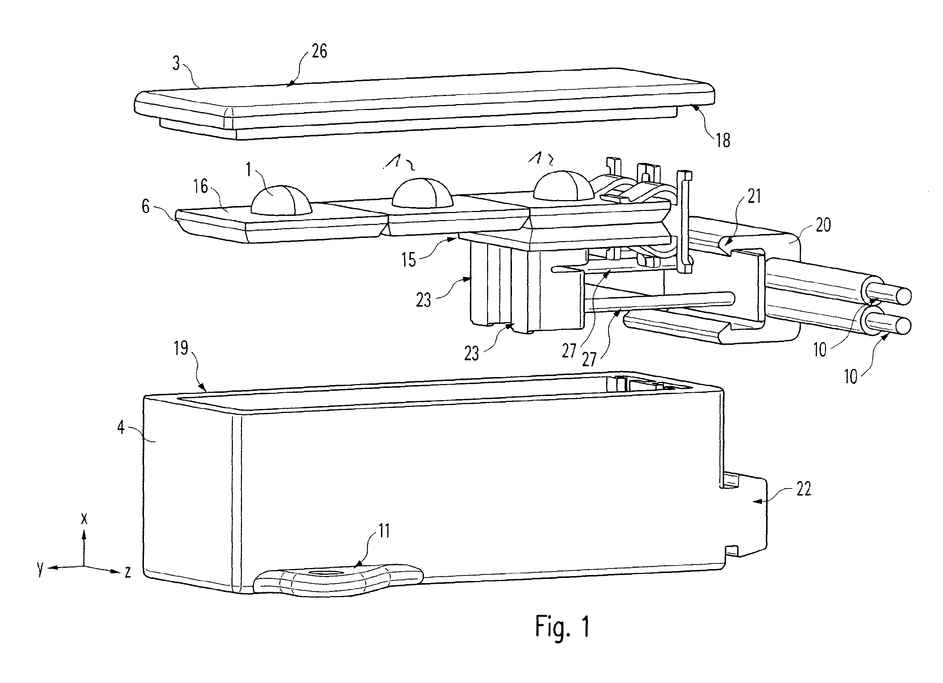

Figur 1 zeigt ein erfindungsgemäßes LED-Modul nach einer ersten bevorzugten Ausführungsform. Das erfindungsgemäße LED-Modul umfasst ein Modul 6, auf welchem vorzugsweise drei LED-Chips 1 aufgebracht sind. Selbstverständlich können auch mehr oder weniger LED-Chips aufgebracht sein. Außerdem kann zumindest eine OLED an Stelle einer anorganischen LED verwendet werden. Die LEDs 1 sind vorzugsweise parallel geschaltet.

Die LED-Chips 1 in Figur 1 sind mit einer Abdeckung bspw. in Form eines Globe Tops überzogen.

Das Modul 6 weist zudem wenigstens einen Teil der Ansteuerelektronik 15 für den wenigstens einen LED-Chip 1 auf. Es kann auch eine Schnittstelle für eine Kommunikationseinrichtung vorgesehen sein. Bei der Elektronik 15 handelt es sich bspw. um einen integrierten Schaltkreis und insbesondere um einen ASIC (Anwendungsspezifische Integrierte Schaltung). Außerdem kann eine Sensorik, wie beispielweise ein Temperatur-, Helligkeits- oder Farbsensor, zur Überwachung des LED-Moduls vorgesehen sein.

Die Elektronik 15 des Moduls ist vorzugsweise nur auf einer Seite des Trägers des Moduls aufgebracht. Vorzugsweise ist die Elektronik auf der Rückseite, also auf der von den LED-Chips 1 abgewandten Seite des Moduls angebracht. Alternativ oder zusätzlich kann sie aber auch auf der gleichen Seite wie der LED-Chip 1 auf dem Träger des Moduls angeordnet sein oder zumindest teilweise im Inneren des Moduls sein.

Die Sensorik ist dabei selbstverständlich so angebracht, dass eine korrekte Messung vorgenommen werden kann. So kann diese separat von der anderen Elektronik angebracht sein. Beispielsweise kann sich ein Lichtsensor auf der Oberfläche des Moduls befinden, während die restliche Elektronik auf der Rückseite angebracht ist.

Die Oberfläche 16 des Trägers des Moduls 6, auf welcher sich die LEDs 1 befinden, ist vorzugsweise reflektierend ausgestaltet. Hierzu kann beispielsweise weiße Farbe oder Lack auf dem Träger des Moduls 6 aufgetragen sein. Es ist auch möglich, eine reflektierende Schicht, beispielsweise eine vorgefertigte Folie auf das Modul 6 aufzubringen. Bei dem Modul 6 handelt es sich vorzugsweise um ein planes Modul.

Wie in Figur 1 dargestellt, ist das Modul 6 mit Hilfe von Kontaktierungsmitteln auf einer Seite des LED-Moduls mit Anschlussleitern 10 verbunden.

Die LED-Chips 1 können Face-Up oder Face-Down auf dem Modul 6 aufgebracht sein. Die LED-Chips 1 können dabei von einer halbkugel- oder kalottenförmigen Vergussmasse umgeben sein, in welcher Farbkonversionspartikel enthalten sein können. Die Farbkonversionsschicht wird dabei vorzugsweise in flüssigem Zustand mit Hilfe eines Dispens-Vorgangs auf die LED-Chips aufgebracht.

Anstelle der Vergussmasse oder zusätzlich dazu kann ein mechanischer Schutz, beispielsweise ein sogenanntes Globe-Top über jedem der LED-Chips angeordnet sein. Das Globe-top besteht vorzugsweise aus transparentem Kunststoff.

Die LEDs können jede Art von monochromatischen LED-Chips, oder mit Farbkonversionsmittel bzw. Leuchtstoff konvertierte LEDs umfassen. Insbesondere können blau oder rot monochromatische und/oder Leuchtstoff-konvertierte LEDs auf dem LED-Modul angeordnet sein.

Die Farbkonversionspartikel der LEDs 1 konvertieren dabei das von dem LED-Chip emittierte Licht wenigstens teilweise in Licht einer höheren Wellenlänge. Durch additive Farbmischung des von dem LED-Chip und von den Farbkonversionspartikeln emittierten Lichts wird vorzugsweise weißes Licht erzeugt.

An einer Seite weist das Modul 6 eine elektrische Kontaktierung 23 auf. Diese ist vorzugsweise als von dem LED-Modul nach unten (weg von den LED-Chips 1) hervorstehender Vorsprung realisiert, in dem sich elektrische Leiter befinden. Die elektrische Kontaktierung 23 ist mit den mindestens zwei Versorgungsleitern 10 elektrisch verbunden.

Ein mit den Leitern 10 fest verbundener Montageadapter 20 sorgt dabei für eine sichere elektrische Kontaktierung und eine stabile Zugentlastung, indem er mechanisch mit einem Teil (Schwalbenschwanz 22) des Gehäuses des LED-Moduls eingreift, was später im Detail erläutert werde wird. Der Montageadapter 20 sorgt zusammen mit dem Gehäuse für einen Schutz gegen äußere Einflüsse wie bspw. Staub oder Feuchtigkeit. Die Versorgungsleiter 10, welche vorzugsweise flexibel sind, ermöglichen ein Verbinden mehrere gehäuster Module 6 zu längeren, flexiblen LED-Ketten.

Das LED-Modul 6 ist in einem Gehäuse 3,4 aufgenommen, das vorzugsweise aus zwei Hälften, einer Unterschale 4 und einer Oberschale 3 besteht. Die Unterschale 4 weist vorzugsweise eine umlaufende Nut auf (in Fig.1 nicht gezeigt), in welche beim Zusammensetzen der Ober- und Unterschale 3,4 ein umlaufender Vorsprung - die sogenannte Feder - der Oberschale 3 eingreift. Die Nut und die Feder sind vorzugsweise derart ausgestaltet, dass eine dichte Verbindung zwischen der Oberschale 3 und der Unterschale 4 im zusammengebauten Zustand des Gehäuses 3,4 ermöglicht wird. Auf diese Weise kann das Gehäuse 3,4 das Modul 6 erfolgreich gegen Umwelteinflüsse wie Staub und Feuchtigkeit schützen.

Vor dem Zusammenbau der beiden Gehäusehälften 3,4 kann zudem fliessfähiges Kunststoffmaterial in die umlaufende Nut eingebracht werden. Dies ist beispielsweise mit Hilfe eines Dispensvorganges möglich. Als Alternative kann auch ein vorgefertigter Zuschnitt von Dichtungsmaterial auf die Oberfläche der Unterschale 4 und damit in die umlaufende Nut aufgebracht werden.

Alternativ kann eine Versiegelung dadurch realisiert werden, dass das Gehäuse 3,4 umspritzt wird. Das Gehäuse 3,4 wird durch das Umspritzen dicht ausgeführt.

An der Oberschale 3 können zusätzlich zur Fixierung von Unter- und Oberschale 3,4 eine oder mehrere Klemmen (in Fig.1 nicht gezeigt) an Ober- und/oder Unterschale angegossen sein. Im zusammengesetzten Zustand des Gehäuses sind die Klemmen fest im Eingriff mit an die Gegenseite gegossenen Gegenstücken. Dadurch wird ein Schnappverschluss realisiert, der einen einfachen Zusammenbau der Gehäuseteile 3,4 ermöglicht. Vorzugsweise ist der Schnappverschluss derart ausgeprägt, dass er nach einmaligem Zusammenbau nicht wieder geöffnet werden kann.

Die beiden Gehäuseteile 3,4 sind vorzugsweise aus Kunststoff mit Hilfe eines Spritzgussverfahrens gefertigt. Die Unterschale 4 weist dabei vorzugsweise Befestigungsanschläge 11 auf, welche mit Hilfe des Spritzgussverfahrens an die Unterschale 4 angegossen sind. Die Befestigungsanschläge weisen eine zentrale Bohrung 11a auf, welche die Befestigung des Gehäuses 3,4 mit Hilfe von Schrauben auf externen Oberflächen ermöglicht.

Die Oberfläche 16 ist vorzugsweise reflektierend ausgebildet. Hierzu kann beispielsweise weißer Lack auf die Oberschale 3 aufgebracht sein.

Oberhalb der LED 1 kann sich dabei eine weitere transluzente Platte befinden, die streuförmige Eigenschaften aufweist. Diese Platte kann auch Teil der Oberschale 3 sein.

Die Oberfläche 26 der Oberschale 3 kann kreisrunde Ausnehmungen aufweisen (in Fig1 nicht gezeigt ist), sodass die LEDs 1 aus den Ausnehmungen hervorragen. Die Ausnehmungen sind vorzugsweise nach Außen hin konisch erweitert. Der Winkel der konischen Ausnehmung ist dabei vorzugsweise 100 bis 150°.

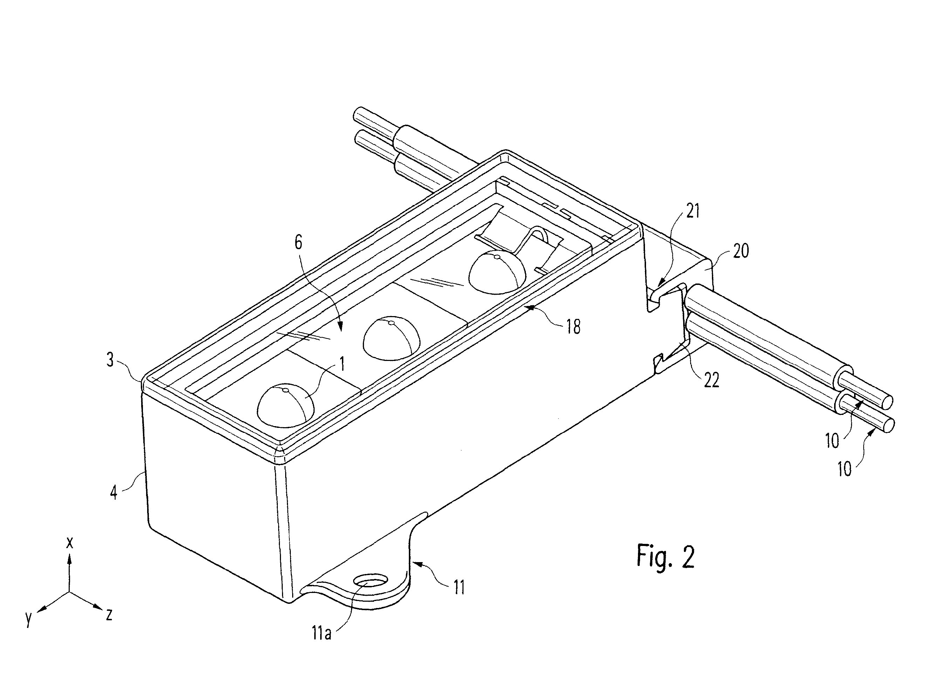

Figur 2 zeigt das erfindungsgemäße LED-Modul in zusammengesetztem Zustand. Dabei befindet sich das Modul 6 im Gehäuse 3,4. Der Montageadapter 20 umgreift die Versorgungsleiter 10 und die elektrische Kontaktierung 23 des LED-Moduls. Die Klemmen 21 des Montageadapters 20 sind dabei clipartig in den Vorsprung der elektrischen Kontaktierung 23 eingerastet.

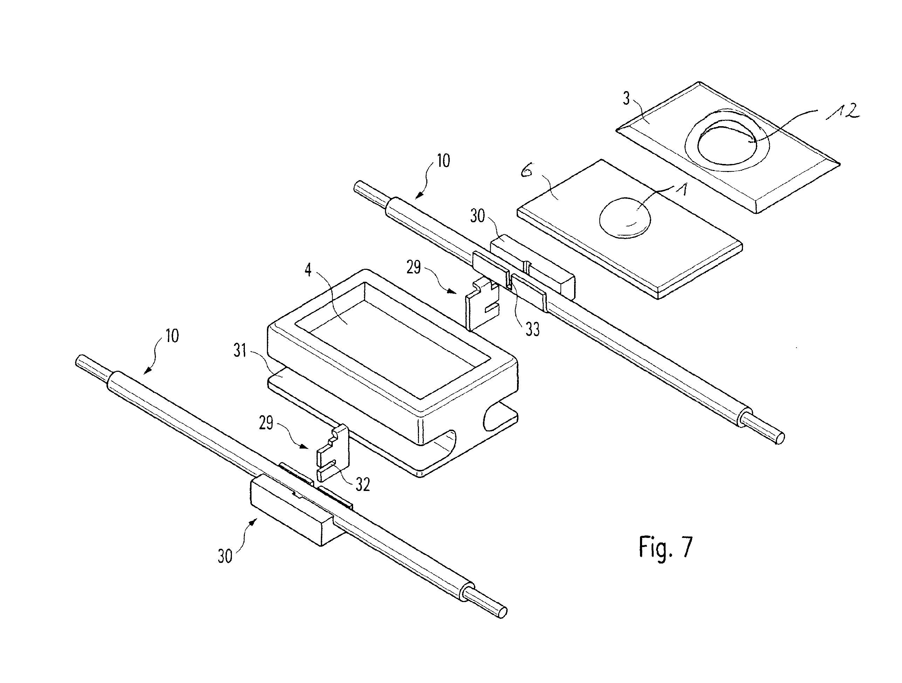

Die Oberschale 3 des Gehäuses ist in dieser Ausführungsform wenigstens im Bereich der LEDs 1 transparent ausgebildet. Vorzugsweise ist jedoch die gesamte Oberschale 3 des Gehäuses transparent ausgebildet. Darüber hinaus kann die Oberschale 3 im Bereich über den LEDs 1 des Moduls 6 linsenförmige Elemente aufweisen. Die linsenförmigen Elemente können in die Oberschale 3 eingegossen sein. Die linsenförmigen Elemente 12 (in Fig. 7 gezeigt) sind vorzugsweise koaxial mit den LEDs bzw. mit den kalotten- oder halbkreisförmigen Vergussmassen oder den Globe Tops der LEDs 1 angeordnet.

Die linsenförmigen Elemente 12 sind vorzugsweise direkt auf die LED-Chips 1 aufgebracht. Die kalottenförmigen Vergussmassen bzw. Globe Tops, welche auf den LED-Chips 1 aufgebracht sein können, ragen aus dem Modul 6 hervor. Die Höhe der kalottenförmigen Vergussmassen bzw. der Globe Tops ist dabei geringer als die Höhe der Oberschale 3. Da die Oberfläche 16 des Moduls 6 vorzugsweise reflektierend ausgebildet sind, kann die Lichtausbeute des von den LEDs 1 emittierten Lichts maximiert werden.

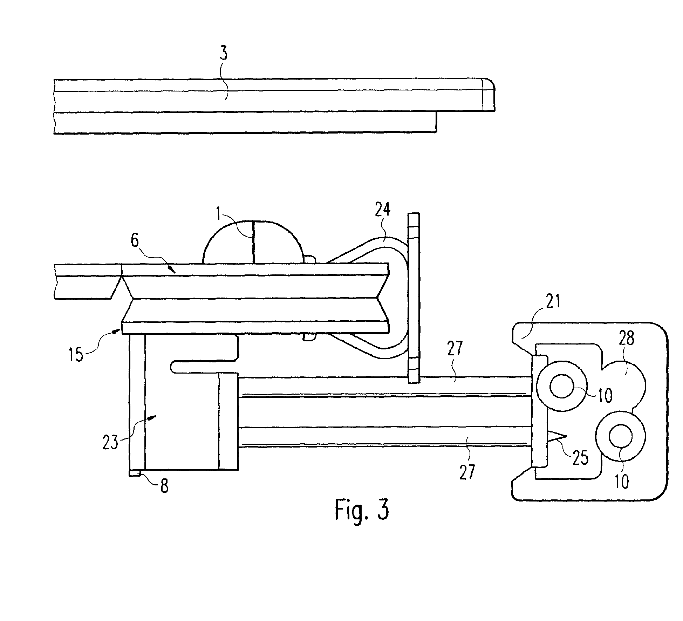

Figur 3 zeigt die erfindungsgemäße elektrische Kontaktierung des LED-Moduls mit den Versorgungsleitern 10.

An einer Seite weist das Modul 6 eine elektrische Kontaktierung 23 auf. Diese ist vorzugsweise als aus dem LED-Moduls herausragende Steckverbindung realisiert, in der sich mindestens zwei voneinander isolierte elektrische Leiter 27 befinden. Diese sind vorzugsweise als steife Leiter ausgebildet, die durch eine Wand der Unterschale 4 des Gehäuses geradlinig hindurchgeführt sind, so dass sie aus dem gehäusten LED-Modul herausstehen. Dadurch ist es möglich, die Leiter 27 für eine elektrische Kontaktierung in die Versorgungsleiter 10 hineinzustecken. In einer bevorzugten Ausführung weisen die Leiter 27 dafür ein spitzes Ende 25 auf. Damit kann die Isolierung der Versorgungsleiter durchstochen werden und eine elektrische Kontaktierung hergestellt werden. Die Leiter 27 sind außerdem so zueinander versetzt, dass sie jeweils einen anderen Versorgungsleiter 10 kontaktieren. Hierfür sind die Leiter 27 hinsichtlich der Höhenerstreckung des LED-Modulgehäuses versetzt.

Bei den Versorgungsleitern 10 kann es sich um mindestens zwei handelsübliche isolierte Drähte handeln. Denkbar ist jedoch auch, dass nur ein Kabel mit mindestens zwei isolierten Litzen verwendet wird. Hier könnte eine elektrische Kontaktierung dadurch erfolgen, dass an Stelle von mehreren steifen Leitern 27 nur einer verwendet wird. Dieser eine kann verschiedene voneinander isolierte elektrische Leitungen führen und verschiedene voneinander isolierte Kontaktbereiche in der Spitze 25 aufweisen.

Ausserdem ist es möglich, als Versorgungsleiter 10 anstelle von Drähten einen oder mehrere Flachleiter zu verwenden. Hierfür wären keine Spitzen 25 notwendig, stattdessen könnten die Leiter 27 auch stumpfe oder flächige Enden aufweisen.

Außerdem kann es vorgesehen sein, über dieselbe Kontaktierung 23 das LED-Modul mit einem Steuerbus bzw. Kommunikationsbus zu verbinden. Dieser kann beispielsweise über ein oder mehrere zusätzliche Leiter realisiert sein. In diesem Fall verfügt das das LED-Modul entsprechend über zusätzliche Leiter 27. Alternativ kann die Kommunikation mit dem Steuerbus natürlich auch drahtlos, bspw. über eine Funkschnittstelle erfolgen.

Allgemein betrachtet gibt es also mehrere Möglichkeiten der elektrischen Kontaktierung des LED-Moduls mit verschiedenartigen Versorgungsleitern. Daher verfügt das LED-Modul über die vorteilhafte Eigenschaft, dass eine elektrische Kontaktierung 23 durch eine andere ersetzt werden kann. Beispielsweise kann so eine Kontaktierung bestehend aus zwei steifen Leitern 27 für zwei Versorgungleiter 10 durch drei stumpfe Leiter, aufweisend einen zusätzliche Busschnittstelle, ersetzt werden. Entsprechend ist es auch denkbar, dass der aus dem LED-Modul herausragende Vorsprung austauschbar ist.

Bei der Auslieferung des LED-Moduls stehen die Leiter 27 aus dem Gehäuse hervor und können dann an im Wesentlichen beliebiger Stelle mit den elektrische Zuleitungen 10 verbunden, bspw. eingestochen werden. Denkbar ist auch, dass ein einmal angeschlossenes LED-Modul wieder entnommen und an einer anderen Stelle angeschlossen wird.

Vorzugsweise befindet sich zwischen den Leiter 27 und den Versorgungsleitern 10 ein Klebeband. Bevor die Leiter 27 auf die Isolierung der Zuleitungen treffen, durchstechen sie das Klebeband. Mit diesem Klebeband kann der Montageadapter 20 auf eine plane Stirnseite des LED-Moduls geklebt werden.

Zusätzlich oder alternativ zum Klebeband kann sich zwischen dem Gehäuse und dem Montageadapter ein Dichtungselement befinden. Es ist auch denkbar, dass das Klebeband so ausgebildet ist, dass es neben der mechanischen Kontaktierung für eine Abdichtung sorgt.

Die Steckverbindung 23 ist wiederum mit dem Modul 6 elektrisch verbunden. Vorzugsweise über mindestens eine Klammer 24 ist hierfür eine elektrische Kontaktierung der Steckverbindung mit dem Modul 6, bzw. mit den LEDs 1 hergestellt.

Der Montageadapter 20 sorgt dabei für eine sichere elektrische Kontaktierung und eine stabile Zugentlastung. Dieser ist hierfür vorzugsweise U-förmig ausgebildet und umschließt die Versorgungsleiter 10 und zumindest einen Teil des Vorsprungs 22 des Gehäuses des LED-Moduls, der die Leiter 27 umgibt.

Zur Fixierung ist die U-Form des Montageadapters derart ausgebildet, dass sie mittels mindestens eines Widerhakens 21 clipartig in mindestens eine Hinterschneidung im Vorsprung des LED-Moduls eingreift.

Unter Berücksichtigung des Umstands, dass sowohl Versorgungsleiter als auch der Vorsprung des LED-Moduls verschiedenartig ausgeführt sein kann, muss der Montageadapter ebenfalls angepasst werden können. Hierfür ist denkbar dass der Montageadapter über mehrere Widerhaken 21 und/oder der Vorsprung des LED-Moduls über mehrere Hinterschneidungen verfügt. Dadurch lässt sich die Größe der Nut 28 zwischen Montageadapter und LED-Modul, in dem die Versorgungsleiter geführt werden, so anpassen, dass eine zuverlässige elektrische Kontaktierung sichergestellt ist. Alternativ ist denkbar, dass zur Fixierung des Montageadapters an das LED-Modul Schrauben verwendet werden. Dadurch lässt sich die Größe der Nut sogar stufenlos anpassen. Außerdem ist es möglich, dass, beispielsweise beim Anschließen des LED-Moduls an einen Flachleiter an Stelle von Drähten, der gesamte Montageadapter durch einen passenden ausgetauscht wird.

Zusammengefügt weisen also Montageadapter und LED-Modul mindestens eine Nut 28 auf, in der die Versorgungsleiter vorzugsweise parallel geführt werden.

Die Nut 28 sind dabei vorzugsweise zwei im Wesentlichen parallele Anschlussführungen, in welchen die Anschlusskabel des Moduls geführt sind. Die Anschlussführungen weisen vorzugsweise über deren gesamte Länge einen gleichen Durchmesser auf. Der Durchmesser kann dabei etwas größer als der Durchmesser der Anschlusskabel gewählt sein. In einer bevorzugten Ausführungsform sind zudem kleine Vorsprünge in den Anschlussführungen vorgesehen, welche ein festes Umklammern der Anschlusskabel innerhalb der Anschlussführung sicherstellen.

Der Durchmesser der Nut 28 kann abschnittsweise geringer als der Kabeldurchmesser der Versorgungsleiter 10 ausgebildet sein. Auf diese Weise wird abschnittsweise eine Presspassung zwischen den Versorgungsleitern 10 und den Nuten erzielt, um die Versorgungsleiter fest in die Nuten einzuklemmen.

Darüber hinaus können die Nuten Verjüngungen aufweisen, welche abschnittsweise den Durchmesser der Nuten verkleinern. Diese hervorstehenden Abschnitte ermöglichen eine Klemmverbindung zwischen den Anschlusskabeln 10 und den Ausnehmungen im zusammengesetzten Zustand des Montageadapters mit dem LED-Modul. Vorzugsweise ist wenigstens eine Verjüngungen vorgesehen, es können jedoch auch mehrerer Verjüngungen vorgesehen sein.

Der Montageadapter 20 kann zudem eine Öffnung aufweisen. Durch diese kann im zusammengesetzten Zustand Einspritzmaterial wie beispielsweise flüssiger Kunststoff bzw. Epoxidmaterial durch die Öffnung des Montageadapters in die Nut 28 eingebracht werden. Die Versorgungsleiter 10 werden dementsprechend von dem eingebrachten flüssigen Material umgeben. Durch ein Trocknen bzw. Aushärten des eingebrachten Materials entsteht so eine Formschlussverbindung zwischen den Montageadapter, LED-Modul und den Versorgungsleitern 10.

In einer weiteren Ausführungsform können die Anschlussführungen in einem inneren Bereich des Gehäuses einen größeren Durchmesser als die Anschlusskabel aufweisen, um eine Raum für einen zuzuführenden Kunststoff zwischen dem Gehäuse, dem Montageadapter und den Versorgungsleiter bereitzustellen. Der Durchmesser der Anschlussführungen in einem Randbereich des Gehäuses kann etwas kleiner gewählt sein als der Durchmesser im Inneren des Gehäuses. Dementsprechend wird eine Presspassung zwischen Anschlusskabel und Kabelführung in einem Randbereich des Gehäuses ermöglicht. Zuzuführender Kunststoff kann somit nicht nach Außen entweichen.

Die Nuten 28 können somit gegenüber der Umwelt abgedichtet werden. Zudem werden auf die Versorgungsleiter 10 longitudinal wirkende Zugkräfte besser auf das Gehäuse 3,4 übertragen, was die elektrische Kontaktierung durch die Leiterspitzen 25 zuverlässiger macht.

Da somit die Nut 28 und, wie oben beschrieben der Schlitz zwischen der Ober- und Unterschale 3,4 abgedichtet sind, ist das Gehäuse des LED-Moduls gegen Umwelteinflüsse wie Staub, Schmutz und Feuchtigkeit geschützt. Durch die erfindungsgemäße Ausführung des Gehäuses 3,4 wird ein Staub- und Feuchtigkeitsschutz der Norm IP66 oder höhere Schutzklasse erzielt.

Durch die Zugentlastung der Versorgungsleiter wird zudem eine widerstandfähige Verkettung von mehreren erfindungsgemäßen LED-Modulen zu einer LED-Kette ermöglicht.

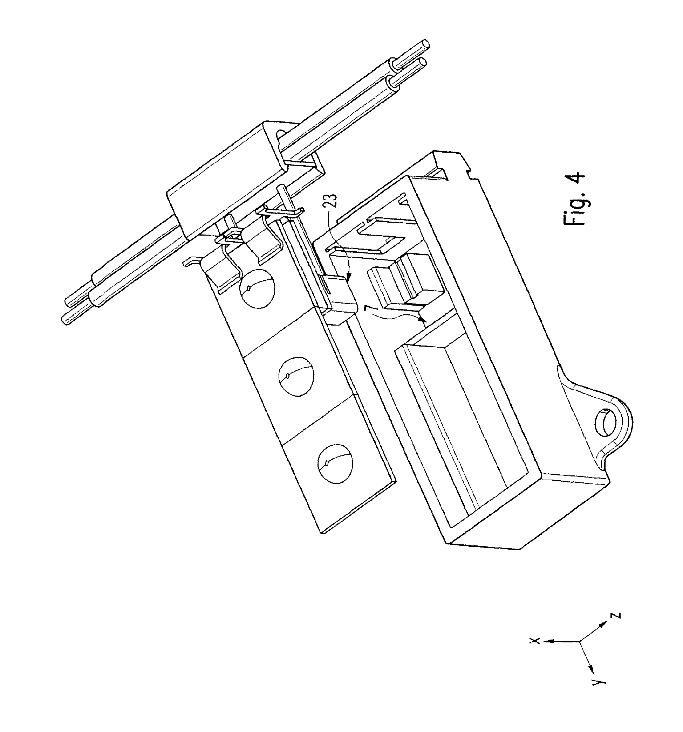

Figur 4 zeigt eine perspektivische Ansicht der Passform des Moduls im Gehäuse. Das Modul 6 umfasst Positioniermittel 23,8, welche eine richtige Positionierung des Moduls 6 innerhalb des Gehäuses 3,4 erleichtern. Die Positioniermittel können beispielsweise eine Platzierungsöffnung 7 sein, welche mit hervorstehenden Profilelementen 23 interagiert, die sich im Inneren des Gehäuses 3,4 im Wesentlichen senkrecht zum Modul 6 erstrecken. Die Platzierungsöffnung 7 kann hierfür eine spezielle Form, beispielsweise Rechtecksform oder Dreiecksform, aufweisen um eine genaue und korrekte Positionierung des Moduls 6 innerhalb des Gehäuses 3,4 zu ermöglichen. Desweiteren kann das Modul 6 einen Platzierungsstift 8 (in Fig3 gezeigt)aufweisen.

Fig. 7 zeigt eine Explosionsansicht einer zweiten bevorzugten Ausführungsform des gehäusten LED-Moduls. Erneut weist das gehäuste LED-Modul ein Modul 6 mit wenigstens einer darauf angeordneten LED 1 auf. Das Modul ist innerhalb eines verschließbaren Gehäuses 3,4 angeordnet. Das Gehäuse 3,4 weist auf zwei gegenüberliegenden Seiten Nuten 31 zum Führen von jeweils einer Leitung 10 auf. Innerhalb jeder Nut befindet sich ein Kontaktierungselement 29. Dieses ist so ausgelegt, dass es in die Isolierung der entsprechenden Leitung beim Einfügen der Leitung in die Nut 31 einschneidet. Die Leitung wird dabei im Wesentlichen rechtwinklig zugeführt. Durch das Einschneiden in die Leitung wird diese mit dem entsprechenden Kontaktierungselement 29 kontaktiert. Die Kontaktierungselemente sind wiederum mit Leitern (nicht dargestellt) elektrisch verbunden. Die Leiter stellen eine elektrische Verbindung zu der mindestens einen LED her. Hierfür können die Leiter beispielsweise mit der Klammer 24 (aus Fig. 3) oder direkt mit dem Modul 6 verbunden sein.

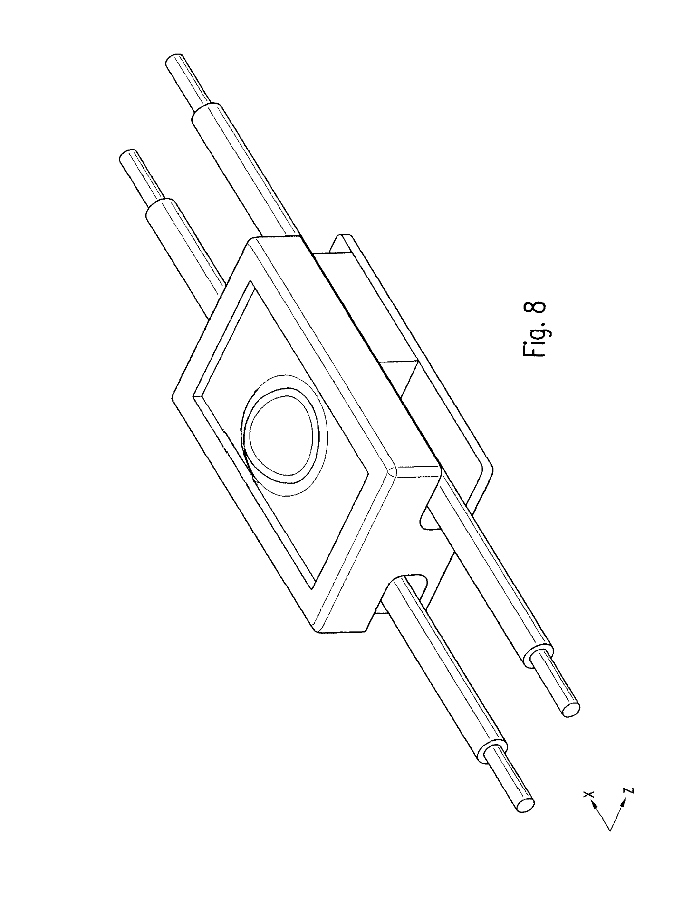

Die Nuten 31 des Moduls befinden sich auf dessen Längsseite. Die Nuten sind dabei auf den Seiten angeordnet, die sich orthogonal zur Ebene befinden, auf der die wenigstens eine LED 1 angebracht ist. Damit sind die Leitungen seitlich der Ausstrahlrichtung des LED-Moduls angeordnet. Das bedeutet, dass die Leitungen so angeordnet sind, dass sie keine Abschattung für das ausgestrahlte Licht verursachen (siehe Fig. 8 - 10).

Das Kontaktierungselement 29 weist einen Schlitz 32 auf. In den Schlitz wird die entsprechende Leitung eingeschoben. Der Schlitz weist eine solche Größe auf, dass beim Hineinschieben die Isolierung der Leitung durchschnitten wird. Alternativ zu dem Schlitz kann das Kontaktierungselement auch eine andere Öffnung aufweisen, beispielsweise eine konisch geformte. Denkbar ist auch, dass eine Leitung durch mehrere Kontaktierungselemente kontaktiert wird.

Das LED-Modul weist außerdem für jede Leitung 10 mindestens eine Klammer 30 auf. Die Klammer 30 umgibt die die Leitung 10 an der Stelle der Kontaktierung mit dem Kontaktierungselement 29. Die Klammer fixiert das LED-Modul mechanisch an einer vorgegebenen Stelle auf den Leitungen.

Die Klammer 30 weist einen Hohlraum 33 auf. Dieser bildet einen Spalt in der Klammer 30. Dieser verläuft im Wesentlichen orthogonal zum Aufnehmer, in dem die Leitung 10 geführt wird. In diesen Hohlraum 33 wird das Kontaktierungselement aufgenommen, wenn eine Kontaktierung mit der Leitung hergestellt wird. Durch die Aufnahme wird das Kontaktierungselement 29 vollkommen oder zu einem großen Teil von der Klammer umgeben. Somit ist dieses von äußeren Einflüssen geschützt. Weiterhin bildet die Klammer 30 nach außen einen Isolierungsschutz. Außerdem dient die Klammer für die Leitung als Zugentlastung. Somit wird die Kontaktierungsstelle der Leitung mechanisch nicht belastet. Insbesondere wird so die Stelle, an der die Isolierung eingeschnitten ist mechanisch entlastet. Die Klammer weist eine solche Größe auf, dass sie in die Nuten des Gehäuses einfügbar ist.

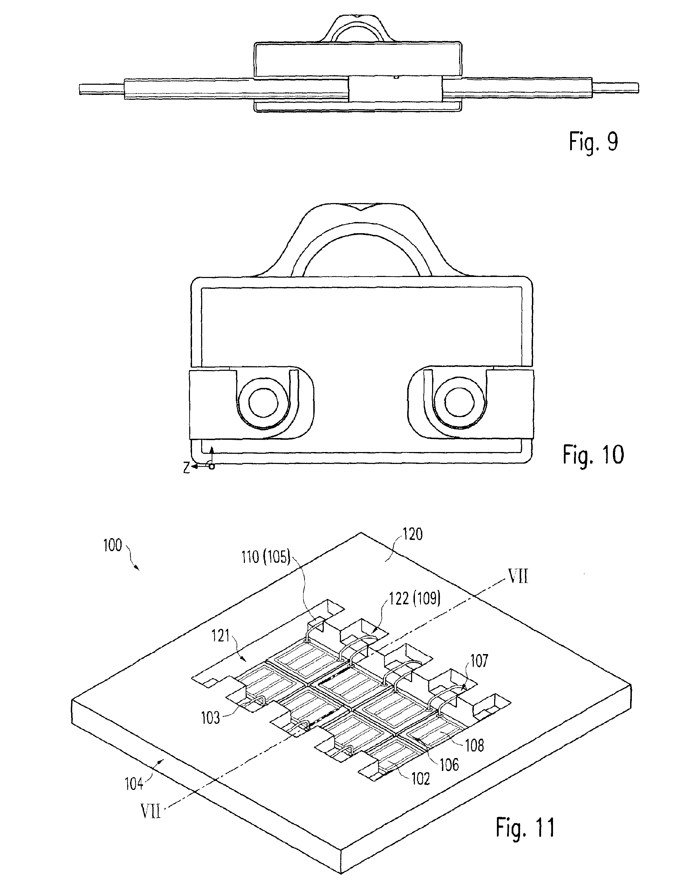

Vorzugsweise ist die Klammer passgenau, womit die Klammer fest in der Nut sitzt und die Leitung kein Spiel hat. Alternativ kann sie etwas kleiner sein als die Abmessungen der Nuten, womit ein Befestigen und herauslösen erleichtert wird. Die Klammer kann entweder der Länge des Gehäuses entsprechen, womit sie den gesamten Hohlraum der Nut ausfüllt, oder, wie in Fig. 9 gezeigt, nur einem Teil der Länge des Gehäuses. Die Klammer besteht aus einem nichtleitenden Material. Dies kann beispielsweise ein Kunststoff oder eine Kunststoffmischung sein. Die Klammer stellt ein zum Gehäuse 3, 4 separates Element dar.

Das Kontaktierungselement wird durch Umspritzen in das LED-Modul integriert. Hierbei kann ein Spritzgussverfahren angewandt werden. Durch das Umspritzen wird das Kontaktierungselement am LED-Modul mechanisch fixiert. Das Kontaktierungselement und das LED-Modul bilden so eine Einheit. Das Kontaktierungselement ist aus einem elektrisch leitfähigen Material. Beispielsweise kann es aus einem Metall oder einer Metalllegierung bestehen.

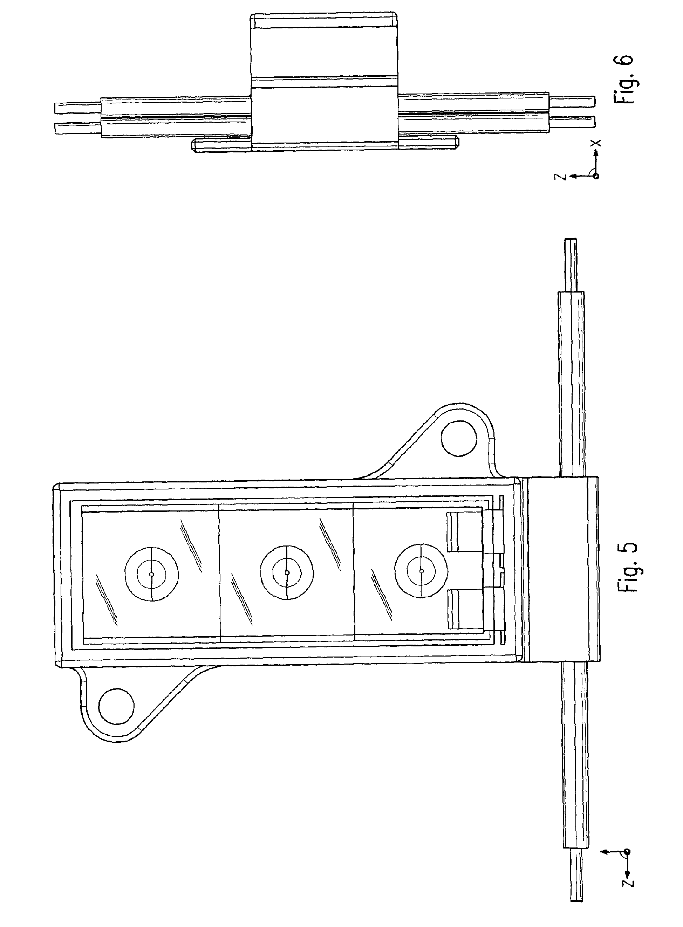

Bezüglich der Merkmale und Funktionalitäten des Gehäuses und der darin sich befindlichen Vorrichtungen in den verschiedenen Ausführungsformen wird auf obige Beschreibung zu Fig. 1 bis 6 verwiesen. In dem Ausführungsbeispiel von Fig. 7 ist schematisch gezeigt, dass sich auf dem Modul 6 eine LED 1 befindet. Diese ist mit einem transparenten halbförmigen Globe Top umgeben. Beispielsweise kann der Globe Top ein oder mehrere lumineszente Materialien und/oder Streupartikel enthalten.

Darüber befindet sich die Oberschale 3. Diese bildet eine transparente Schicht. Die Oberschale kann optional noch zusätzliche optische Eigenschaften aufweisen, wie beispielsweise durch Ausbildung eines Linsenelementes 12, das vorzugsweise nach Aussen vorsteht.

In Fig.11 bis 13 wird ein weiteres Ausführungsbeispiel des Moduls 6 gezeigt. Wie im Weiteren beschrieben, weist dieses vorzugsweise mehrere LEDs 102 auf. Die Stromversorgung der LEDs 102 kann dabei mit Bonddrähten 103 realisiert werden. Durch einen mehrteiligen Rahmen des Moduls 6 wird ein besonderer Schutz der LEDs 102 und der Bonddrähte 103 erreicht. Daher ist es denkbar, dass die Oberschale 3 des Gehäuses 3,4 weggelassen werden kann.

Fig. 11 zeigt die weitere Ausführungsform des Moduls 6, wobei dieses hier einen Träger T' und ein mehrteiligen Rahmen 110, 120 aufweist. Auf dem Träger befindet sich mindestens eine LED 102, wobei vorzugsweise eine Vielzahl von LEDs eingesetzt wird.

Dabei ist zu beachten, dass zur Vereinfachung in Fig.11 das Gehäuse 3,4, sowie die Anschlussvorrichtungen 23, 24, 27 an der Seite und auf der Unterseite des Moduls weggelassen worden sind. Das Modul 6 kann mit oben beschriebenen Merkmalen in das Gehäuse 3,4 eingebaut mit den Versorgungsleitern 10 kontaktiert werden. Dabei kann die Kontaktierungsklammer 24 eine elektrische Verbindung zwischen den Bonddrähten 103 und den Leitern 27 herstellen.

Beim Einbau des Moduls 6 ist lediglich entscheidend, dass die LEDs 102 in Richtung der Oberschale 3 leuchten. Das Modul kann jedoch von oben betrachtet sowohl längs als auch quer in das Gehäuse eingebaut werden.

Der Rahmen besteht aus einem ersten Rahmenteil 110, das den ersten Rahmenbereich 106 und den zweiten Rahmenbereich 107 aufweist, und einem zweiten Rahmenteil 120, das auf dem ersten Rahmenteil 110 angeordnet ist, so dass der zweite Rahmenbereich 107 des ersten Rahmenteils 110 wenigstens teilweise abgedeckt ist. Dieses Ausführungsbeispiel wird an späterer Stelle der Beschreibung noch eingehender erläutert.

Der Leuchtdioden-Chip 102 emittiert vorzugsweise ein Licht einer ersten Wellenlänge. Der Leuchtdioden-Chip 102 ist mit wenigstens einem Draht 103 verbunden. Das Modul 6 weist ferner einen Rahmen 104 auf, der den wenigstens einen Leuchtdioden-Chip 102 umrandet. Der Rahmen weist ferner wenigstens einen Steg 105, im vorliegenden, bevorzugten Ausführungsbeispiel zwei Stege 105 auf. Mittels dieser Stege 105 wird der Rahmen in wenigstens einen ersten Rahmenbereich 106 und wenigstens einen zweiten Rahmenbereich 107 eingeteilt. Der erste Rahmenbereich 106 weist dabei den wenigstens einen Leuchtdioden-Chip 102 auf. Wie Fig.11 zu entnehmen ist, sind innerhalb eines einzigen Rahmens 104 mehrere Leuchtdioden-Chips 102 untergebracht. Ebenfalls ist auch eine Gitterstruktur bzw. Gitterunterteilung im Rahmen 104 denkbar. Dadurch kann erreicht werden, dass durch das Gitter die mehreren Leuchtdioden-Chips 2 einzeln oder jeweils in Gruppen eingerahmt sind. Die einzelnen Leuchtdioden-Chips 102 oder Gruppen von Leuchtdioden-Chips 102 können sodann unabhängig von den jeweils anderen Leuchtdioden-Chips 102 oder Gruppen von Leuchtdioden-Chips 102 mit einer Schicht 108 versehen werden. Auf diese Weise ist es möglich, verschiedene Materialien als Schicht 108 auf die Leuchtdioden-Chips 108 aufzutragen, um beispielsweise je Leuchtdioden-Chip 102 bzw. Gruppe von Leuchtdioden-Chips 102 unterschiedliche Farben erzeugen zu können. Die Schicht 108 kann Leuchtstoffteilchen und Streuteilchen enthalten.

Außerdem können sich oberhalb der Schicht 108 eine oder mehrere vorgefertigte Linsen befinden.

Ferner stellt der erste Rahmenbereich 106 vorzugsweise eine seitlich Begrenzung für eine über dem Leuchtdioden-Chip 102 aufgebrachte, lichtdurchlässige Schicht 108 dar. Der zweite Rahmenbereich 107 stellt zudem vorzugsweise ebenfalls einen Schutzbereich für den wenigstens einen Draht 103 dar. Wie auch im ersten Ausführungsbeispiel, ist der Draht 103 auch in diesem Ausführungsbeispiel vorzugsweise auf den Leuchtdioden-Chip 102 im ersten Rahmenbereich 106 und an eine Anschlussstelle A', beispielsweise eine Leiterbahn L', gebondet. Dabei verläuft der Draht 103 bevorzugt vom ersten Rahmenbereich 106 über den Steg 105 gebogen in den zweiten Rahmenbereich 107.

Gemäß dieser zweiten Ausführungsform ist der Rahmen 104 wenigstens zweiteilig aus einem ersten Rahmenteil 110 und einem zweiten Rahmenteil 120 gebildet. Der zweite Rahmenteil 120 ist dazu vorzugsweise auf dem ersten Rahmenteil 110 angeordnet.

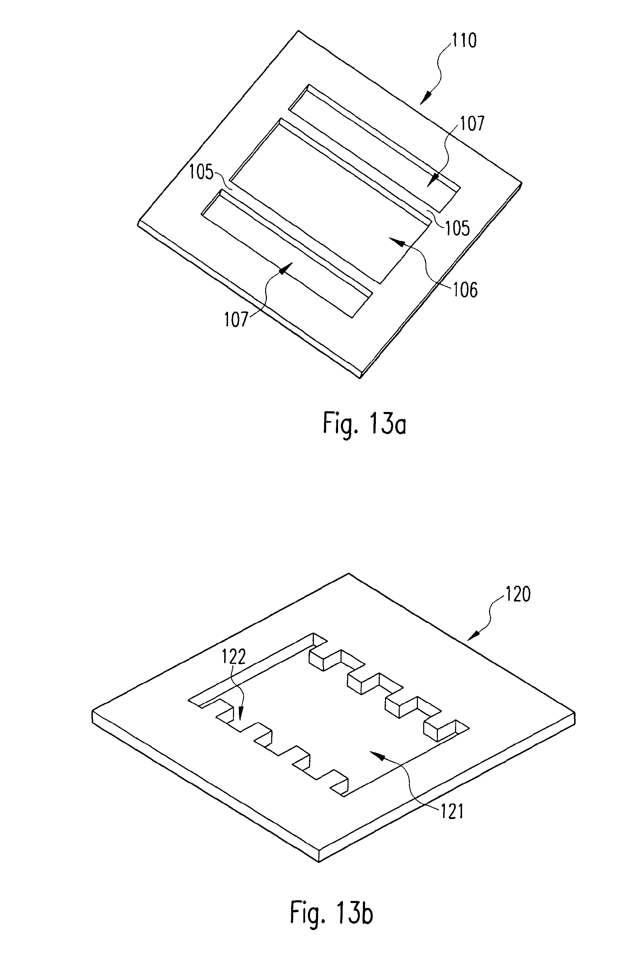

Figur 13a zeigt eine bevorzugte Ausführungsform eines ersten Rahmenteils 110. Der erste Rahmenteil 110 weist vorzugsweise sowohl den ersten Rahmenbereich 106 als auch den zweiten Rahmenbereich 107 auf. Getrennt sind die beiden Rahmenbereiche 106, 107 vorzugsweise durch den wenigstens einen Steg 105, welcher besonders vorzugsweise integral mit dem ersten Rahmenteil 110 ausgebildet ist. Der Steg kann, wenn er integral mit dem ersten Rahmenteil 110 ausgebildet ist, auch flacher gebildet sein, wodurch die Höhe der Leuchtdiodenanordnung 100 besonders optimal gestaltet werden kann. Bedingt durch die seitliche Begrenzung des ersten Rahmenteils 106 und den dadurch möglichen Einsatz von Dispensmaterialien mit einer geringen Viskosität ist somit die Gestaltungsmöglichkeit der Leuchtdiodenanordnung 100 bzw. der Schicht 108 verbessert, wobei gleichzeitig Dispensmaterial eingespart werden kann, beispielsweise im Vergleich zum Globe-top-Ansatz.

Figur 13b zeigt ferner den zweiten Rahmenteil 120. Der zweite Rahmenteil 120 weist vorzugsweise eine Öffnung 121 sowie wenigstens eine von der Öffnung ausgehende Nut 122 auf.

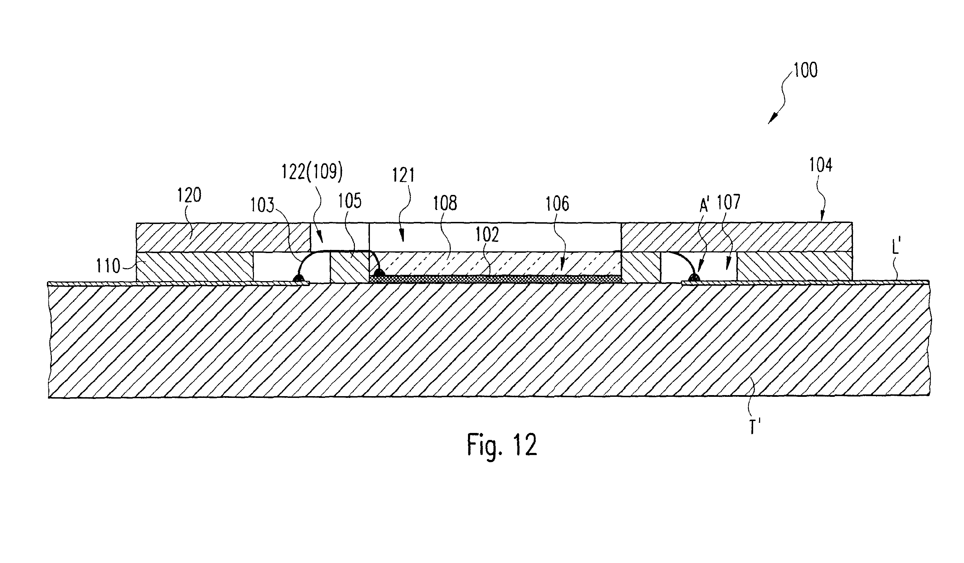

Figur 12 zeigt die Schnittansicht der zusammengesetzten Modul 6. Der zweite Rahmenteil 120 ist auf dem ersten Rahmenteil 110 angeordnet. Aufgrund der in dem zweiten Rahmenteil 107 befindlichen Öffnung 121 liegt der erste Rahmenbereich 106 des ersten Rahmenteils 110 vorzugsweise nach oben hin frei. Somit kann im zusammengebauten Zustand die Schicht 108 einfach auf den Leuchtdioden-Chip 102 im ersten Rahmenbereich 106 aufgebracht werden. Auf diese Weise ist der Draht 103 im ersten Rahmenbereich 106 sicher in der Schicht 108 eingebettet. Ferner kann das Licht, welches vom Leuchtdioden-Chip 102 emittiert wird, frei nach oben abstrahlen.

Die Nut 122 erstreckt sich vorzugsweise oberhalb des Steges 105 vom ersten Rahmenbereich 106 bis hin zum zweiten Rahmenbereich 107 des ersten Rahmenteils 110 vorzugsweise in der Form eines Pfades 109, so dass außerdem der zweite Rahmenbereich 107 des ersten Rahmenteils 110 wenigstens teilweise freigelegt ist. Auf diese Weise kann der wenigstens eine Draht 103 sicher von den Leuchtdioden-Chips 102 im ersten Rahmenbereich 106 über den Steg 105 gebogen zu den Anschlussstellen A', die in den zweiten Rahmenbereich 107 angeordnet sind, verlaufen, wobei der Draht 103 in dem Pfad 109, gebildet durch die Nut 122, geschützt angeordnet ist. Die Nut 123 ist dabei vorzugsweise so gebildet, dass der zweite Rahmenbereich 107 geringfügig größer als der Durchmesser des Bonddrahtes 103 freigelegt ist, um einen größtmöglichen Schutz des Bonddrahtes 103, eben vorzugsweise durch eine maximale Abdeckung des zweiten Rahmenbereiches 107 durch den ersten Rahmenteil 110, zu gewährleisten. Besonders vorzugsweise können, insbesondere in dem Fall, in dem mehrere Leuchtdioden-Chips 102 innerhalb des ersten Rahmenbereichs 106 angeordnet sind, mehrere Nuten 122 im zweiten Rahmenteil 120 vorgesehen sein. Auf diese Weise können die mehreren, vom ersten Rahmenbereich 106 in den zweiten Rahmenbereich 107 verlaufenden Drähte 103 jeweils einzeln oder in Gruppen über den Steg 105 durch jeweils eine Nut 122 bzw. einen Pfad 109 verlaufen, und sind somit aufgrund schmaler ausgebildeter Nuten 122 sicher geschützt vor mechanischen Einflüssen angeordnet.

Der Schutz für den bzw. die Drähte 103 gegenüber einer einteiligen Ausgestaltung ist somit dahingehend verbessert, dass der zweite Rahmenteil 120 erst nach dem Bonden der Bonddrähte 103 aufgebracht werden kann. Wenn der erste Rahmenteil 110 auf dem Träger T' aufgebracht ist, ist eine gute Zugänglichkeit der beiden Rahmenbereiche 106, 107 gewährleistet, da diese nach oben hin offen gestaltet und angeordnet sind. Der bzw. die Bonddrähte 103 können somit besonders einfach an den Leuchtdioden-Chip 102 im ersten Rahmenbereich 106 und die Anschlussstelle A' im zweiten Rahmenbereich 107 gebondet werden. Durch den nach dem Bonden auf den ersten Rahmenteil 110 aufgebrachten zweiten Rahmenteil 120 ist sodann der erste Rahmenbereich 107 derart abgedeckt, dass der Bonddraht 103 sicher von oben geschützt in diesem Bereich 107 angeordnet ist. Bei der Gestaltung des ersten Rahmenteils 110 muss daher keine Rücksicht auf eine Zugänglichkeit der Kontakte beim Bonden genommen werden, da der zweite Rahmenbereich 107 erst durch das nachträgliche Anordnen des zweiten Rahmenteils 120 wenigstens teilweise abgedeckt wird. Ferner wird beim Aufsetzen des zweiten Rahmenteils 120 auf den ersten Rahmenteil 110 durch die Nuten 122 Pfade 109 über den Stegen 105 gebildet, innerhalb derer die Drähte 103 sicher geschützt vom ersten Rahmenbereich 106 in den zweiten Rahmenbereich 107 gebogen verlaufend angeordnet werden können. Somit wird die Zugänglichkeit der Drähte 103 beim Bonden verbessert, während diese dennoch gleichzeitig besonders gut vor mechanischen Einflüssen von außen geschützt sind.

Die Erfindung ist nicht auf die gezeigten Ausführungsarten beschränkt. Vielmehr ist eine Kombination der beschriebenen Merkmale möglich. So sind sämtliche beschriebenen Merkmale bezüglich einer Ausgestaltung des Gehäuses 3, 4 mit den darin befindlichen Vorrichtungen aus Fig. 1 - 6 auch auf die zweite Ausführungsform aus Fig. 7 - 10 anwendbar. Außerdem sind die in Fig. 11 - 13 gezeigten Merkmale sowohl auf die erste Ausführungsform aus Fig. 1 - 6, als auch auf die zweite Ausführungsform aus Fig. 7 - 10 anwendbar.

## Patentansprüche

1. Gehäustes LED-Modul, aufweisend ein Modul (6) mit wenigstens einem darauf angeordneten LED-Chip (1), wobei das Modul (6) innerhalb eines verschließbaren Gehäuses (3,4) angeordnet ist,
**dadurch gekennzeichnet, dass** das Gehäuse (3,4) an einer Stirnseite mindestens zwei durch die Wand des Gehäuses nach außen hindurchgehende und somit exponierte, vorzugsweise steife Leiter (27) aufweist, die dazu ausgelegt sind, durch Einschneiden in die Isolierung mindestens zweier im Wesentlichen rechtwinklig zugeführter Versorgungsleiter (10) diese elektrisch zu kontaktieren.

2. Gehäustes LED-Modul nach Anspruch 1,
wobei zur Zugentlastung das Gehäuse in einen Montageadapter (20) eingreift, der mit den Versorgungsleiter (10) verbunden ist,
wobei vorzugsweise das Gehäuse (3,4) und der Montageadapter (20) mechanisch kontaktierbar sind, indem der Montageadapter U-förmig ausgebildet ist und dabei vorzugsweise clipartig in eine Hinterschneidung (22) des Gehäuses (3, 4) eingreift, wobei das Gehäuse mehrere Hinterschneidungen aufweisen kann,
wobei weiterhin vorzugsweise das Gehäuse und der Montageadapter bei Zusammenfügen eine Nut (28) aufweisen, durch die die Versorgungsleiter (10) geführt werden, wobei sich die Größe der Nut an die Versorgungsleiter so anpassen lässt, dass eine elektrische Kontaktierung sichergestellt ist.

3. Gehäustes LED-Modul nach einem der vorherigen Ansprüche,
wobei das LED-Modul eine Steckverbindung (23) aufweist, in die die nach außen stehenden Leiter (27) eingeschoben sind, wobei diese als steife Leiter ausgebildet sind.

4. Gehäustes LED-Modul nach einem der Ansprüche 2 oder 3,
wobei die nach außen stehenden Leiter (27) Spitzen (25) aufweisen, die in ihrem Niveau so versetzt sind, dass sie unterschiedliche Versorgungsleiter (10) kontaktieren.

5. Gehäustes LED-Modul nach einem der Ansprüche 2 bis 4,
wobei sich zwischen dem Gehäuse und dem Montageadapter ein Dichtungselement befindet, das vorzugsweise von den nach außen stehenden Leitern (27) durchstochen wird.

6. Gehäustes LED-Modul nach einem der vorherigen Ansprüche,
wobei die elektrische Kontaktierung innerhalb des gehäusten LED-Moduls über eine Klammer (24) erfolgt, die eine elektrische Verbindung zwischen dem vorzugsweise steifen Leiter (27) und der Oberseite des Moduls herstellt.

7. Gehäustes LED-Modul nach einem der vorherigen Ansprüche,
wobei die Oberfläche des Moduls eine nach außen konisch erweiterte Ausnehmung aufweist, in welcher die LED in Richtung Gehäuseäußeren exponiert ist.

8. Gehäustes LED-Modul nach einem der vorherigen Ansprüche,
wobei die LED auf einer ebenen Oberfläche des Moduls angebracht ist und über der LED eine transluzente Platte, die vorzugsweise streuförmige Eigenschaften aufweist, angeordnet ist, wobei optional die transluzente Platte Teil einer Oberschale des Moduls ist.

9. Gehäustes LED-Modul nach einem der vorherigen Ansprüche,
wobei auf jeder LED ein linsenförmiges Element (12) angebracht ist.

10. Gehäustes LED-Modul nach einem der vorherigen Ansprüche,
wobei das Gehäuse zweiteilig ausgebildet ist und die beiden Gehäuseteile (3, 4) mit Hilfe von Schnappverschlüssen verbindbar sind.

11. Gehäustes LED-Modul nach einem der vorherigen Ansprüche,
wobei das Gehäuse Positioniermittel umfasst, welche derart ausgestaltet sind, dass ein Verschieben des Moduls im Inneren des Gehäuses verhindert wird,
wobei die Positioniermittel vorzugsweise wenigstens eines von dem Gehäuse hervorstehendes Profilelement (23, 8) umfassen, welche in einer Nut des Moduls geführt wird.

12. Gehäustes LED-Modul nach einem der vorherigen Ansprüche,
wobei das Gehäuse aus einer Oberschale (3) und einer Unterschale (4) besteht, welche verbindbar sind,
wobei vorzugsweise die Oberschale einen optisch durchlässigen Bereich umfasst, der eine Streuwirkung, eine Reflektorwirkung und/oder eine Farbkonversionswirkung aufweist,
wobei weiter bevorzugt das Gehäuse eine wenigstens teilweise transparente Oberschale aufweist,
wobei vorzugsweise der optisch durchlässige Bereich der Oberschale ein linsenförmiger Bereich ist, der vorzugsweise koaxial mit der LED angeordnet ist.

13. Gehäustes LED-Modul nach einem der vorherigen Ansprüche,
wobei die LED eine monochromatische LED ist, welche von einem vorzugsweise transparenten kalotten- oder halbförmigen Globe-top umgeben ist.

14. Gehäustes LED-Modul nach einem der vorherigen Ansprüche,
wobei die LED von einer vorzugsweise kalotten- oder halbförmigen Vergussmasse aus gehärtetem Kunststoff umgeben ist, wobei in der Vergussmasse Farbkonversionspartikel eingeschlossen sind, welche das von der LED abgegebene Licht wenigstens teilweise in ein Licht einer anderen Wellenlänge konvertieren.

15. Gehäustes LED-Modul nach einem der vorherigen Ansprüche,
wobei das gehäuste LED-Modul eine Elektronik zur Ansteuerung und Überwachung der LED aufweist, die sich vorzugsweise auf der Rückseite des Moduls befindet.

16. LED-Kette, aufweisend mehrere über flexible Leiter (10) verbundene LED-Module nach einem der vorhergehenden Ansprüche.

17. Beleuchtungssystem, aufweisend mindestens ein gehäustes LED-Modul nach einem der Ansprüche 1 bis 15 und einen Bus zur Stromversorgung und Steuerung des mindestens einen gehäusten LED-Moduls.

## Claims

1. Housed LED module having a module (6) with at least one LED chip (1) arranged thereon,
wherein the module (6) is arranged within a lockable housing (3,4), **characterized in that** the housing (3,4) has on a face side at least two conductors (27), going through the wall of the housing to the outside and thus exposed, and preferably stiff, that are designed, by cutting into the insulation of at least two essentially rectangularly fed supply conductors (10), to electrically contact these.

2. Housed LED module according to claim 1,
wherein the housing engages, for pull relief, in an installation adapter (20) connected with the supply conductor (10),
wherein the housing (3,4) and the installation adapter (20) are preferably mechanically contactable by the installation adapter being U-shaped while preferably engaging clip-like into a back taper (22) of the housing (3, 4), wherein the housing can have several back tapers,
wherein furthermore preferably the housing and the installation adapter have a groove (28) upon assembly through which the supply conductor (10) are guided, wherein the size of the groove can be adapted to the supply conductor in such a way that electrical contacting is ensured.

3. Housed LED module according to one of the preceding claims, wherein the LED module has a plug connection (23) into which the outwards positioned conductors (27) are inserted, wherein these are configured as stiff conductors.

4. Housed LED module according to one of the claims 2 or 3, wherein the outwards positioned conductors (27) have tips (25) that are offset in their level in such a way that they contact different supply conductors (10).

5. Housed LED module according to one of the claims 2 to 4, wherein between the housing and the installation adapter is a sealing element that is preferably pierced by the outwards positioned conductors (27).

6. Housed LED module according to one of the preceding claims, wherein the electrical contacting within the housed LED module takes place via a clamp (24) that establishes an electrical connection between the preferably stiff conductor (27) and the top side of the module.

7. Housed LED module according to one of the preceding claims, wherein the surface of the module has an outwards conically expanding recess in which the LED is exposed towards the outside of the housing.

8. Housed LED module according to one of the preceding claims, wherein the LED is attached to a plane surface of the module and over the LED is arranged a translucent board that has preferably diffusing properties, wherein optionally the translucent board is part of an upper shell of the module.

9. Housed LED module according to one of the preceding claims, wherein on each LED a lens-shaped element (12) is attached.

10. Housed LED module according to one of the preceding claims, wherein the housing is formed in a two-piece manner and the two housing parts (3, 4) can be connected with the help of snap locks.

11. Housed LED module according to one of the preceding claims,
wherein the housing comprises positioning means which are designed in such a way that moving the module inside the housing is prevented,
wherein the positioning means preferably comprise at least one profile element (23, 8) protruding from the housing that is guided in a groove of the module.

12. Housed LED module according to one of the preceding claims,
wherein the housing consists of an upper shell (3) and a lower shell (4) which can be connected,
wherein preferably the upper shell comprises an optically permeable region that has a diffusion effect, reflecting effect and/or a color conversion effect,
wherein furthermore preferred the housing has an at least partially transparent upper shell,
wherein preferably the optically permeable region of the upper shell is a lens-shaped region that is preferably coaxially arranged with the LED.

13. Housed LED module according to one of the preceding claims, wherein the LED is a monochromatic LED which is surrounded by a preferably transparent dome-shaped or half-shaped globe top.

14. Housed LED module according to one of the preceding claims, wherein the LED is surrounded by a preferably dome-shaped or half-shaped casting compound of hardened plastic, wherein color conversion particles are embedded in the casting compound that convert the light emitted by the LED at least partially into a light of a different wavelength.

15. Housed LED module according to one of the preceding claims, wherein the housed LED module has an electronic system for actuating and monitoring the LED that is preferably on the rear side of the module.

16. LED chain, having several LED modules according to one of the preceding claims connected via flexible conductors (10).

17. Lighting system, having at least one housed LED module according to one of the claims 1 to 15 and a bus for power supply and control of the at least one housed LED module.

## Revendications

1. Module de LED encapsulé ayant un module (6) comportant au moins une puce LED (1) disposée sur celui-ci,
dans lequel le module (6) est disposé à l'intérieur d'un boîtier verrouillable (3, 4), **caractérisé en ce que** le boîtier (3, 4) possède sur un côté frontal au moins deux conducteurs (27) traversant la paroi du boîtier vers l'extérieur et donc exposés, et de préférence rigides, en coupant l'isolation d'au moins deux conducteurs d'alimentation essentiellement rectangulaires (10), pour entrer en contact électriquement avec ceux-ci.

2. Module de LED encapsulé selon la revendication 1,
dans lequel le boîtier se met en prise, pour soulager la traction, dans un adaptateur d'installation (20) relié au conducteur d'alimentation (10),
dans lequel le boîtier (3, 4) et l'adaptateur d'installation (20) peuvent de préférence entrer en contact mécaniquement par l'intermédiaire de l'adaptateur d'installation en forme de « U » tandis qu'il se met en prise, de préférence, par encliquetage dans une dépouille (22) du boîtier (3, 4), dans lequel le boîtier peut avoir plusieurs dépouilles,
dans lequel, de préférence, le boîtier et l'adaptateur d'installation possèdent de plus, une rainure (28) pendant l'assemblage à travers laquelle le conducteur d'alimentation (10) est guidé, dans lequel la dimension de la rainure peut être adaptée au conducteur d'alimentation de manière à ce que le contact électrique soit assuré.

3. Module de LED encapsulé selon l'une des revendications précédentes, dans lequel le module de LED possède une jonction à fiche (23) dans laquelle sont insérés les conducteurs positionnés à l'extérieur (27), dans lequel ceux-ci sont configurés comme des conducteurs rigides.

4. Module de LED encapsulé selon l'une des revendications 2 ou 3, dans lequel les conducteurs positionnés à l'extérieur (27) possèdent des embouts (25) étant décalés à leur niveau de manière à ce qu'ils entrent en contact avec différents conducteurs d'alimentation (10).

5. Module de LED encapsulé selon l'une des revendications de 2 à 4, dans lequel entre le boîtier et l'adaptateur d'installation se trouve un élément de scellement étant de préférence percé par les conducteurs positionnés à l'extérieur (27).

6. Module de LED encapsulé selon l'une des revendications précédentes, dans lequel le contact électrique à l'intérieur du module de LED encapsulé s'effectue par l'intermédiaire d'un serre-fils (24) qui établit une connexion électrique entre, de préférence, le conducteur rigide (27) et le côté supérieur du module.

7. Module de LED encapsulé selon l'une des revendications précédentes, dans lequel la surface du module possède un renfoncement se développant de façon conique vers l'extérieur dans lequel la LED est exposée vers l'extérieur du boîtier.

8. Module de LED encapsulé selon l'une des revendications précédentes, dans lequel la LED est fixée à une surface plane du module et sur ladite LED est disposée une plaque translucide ayant de préférence des propriétés diffusantes, dans lequel la plaque translucide fait éventuellement partie d'une enveloppe supérieure du module.

9. Module de LED encapsulé selon l'une des revendications précédentes, dans lequel sur chaque LED est fixé un élément en forme de lentille (12).

10. Module de LED encapsulé selon l'une des revendications précédentes, dans lequel le boîtier est formé de deux parties et les deux parties de boîtier (3, 4) peuvent être reliées à l'aide de verrous à encliquetage.

11. Module de LED encapsulé selon l'une des revendications précédentes,
dans lequel le boîtier comprend des moyens de positionnement étant conçus de manière à empêcher un déplacement du module à l'intérieur du boîtier,
dans lequel les moyens de positionnement comprennent, de préférence, au moins un élément profilé (23, 8) dépassant du boîtier étant guidé dans une rainure du module.

12. Module de LED encapsulé selon l'une des revendications précédentes,
dans lequel le boîtier consiste en une enveloppe supérieure (3) et une enveloppe inférieure (4) pouvant être reliées,
dans lequel l'enveloppe supérieure comporte, de préférence, une zone perméable optiquement ayant un effet de diffusion, un effet réfléchissant et/ou un effet de conversion de couleur,
dans lequel il est davantage préférable que le boîtier ait au moins une enveloppe supérieure partiellement transparente,
dans lequel la zone perméable optiquement de l'enveloppe supérieure est, de préférence, une zone en forme de lentille étant, de préférence, disposée coaxialement par rapport à la LED.

13. Module de LED encapsulé selon l'une des revendications précédentes, dans lequel la LED est une LED monochromatique étant entourée, de préférence, par un sommet en forme de dôme ou de demi-dôme transparent.

14. Module de LED encapsulé selon l'une des revendications précédentes, dans lequel la LED est entourée, de préférence, par un composant de moulage en forme de dôme ou de demi-dôme en plastique dur, dans lequel les particules de conversion de couleur sont intégrées dans le composant de moulage qui convertit la lumière émise par la LED au moins partiellement en une lumière d'une longueur d'onde différente.

15. Module de LED encapsulé selon l'une des revendications précédentes, dans lequel le module de LED encapsulé possède un système électronique servant à actionner et à contrôler la LED qui est, de préférence, situé sur le côté arrière du module.

16. Chaîne LED, disposant de plusieurs modules de LED selon l'une des revendications précédentes, raccordée par l'intermédiaire de conducteurs souples (10).

17. Système d'éclairage, ayant au moins un module de LED encapsulé selon l'une des revendications de 1 à 15 ainsi qu'un bus destiné à alimenter et contrôler l'au moins un module de LED encapsulé.
